# EUROPEAN PATENT APPLICATION

(11) **EP 4 518 589 A1**
(43) Date of publication of application: **05.03.2025**
(21) Application number: 24194297.8
(22) Date of filing: 13.08.2024
(51) Int. Cl.: H05K 1/11, H05K 3/34, H05K 1/02, H01R 13/66

(54) **CONNECTOR BOARD**

(30) Priority: 01.09.2023 JP 2023142525
(71) Applicant: Hirakawa Hewtech Corporation, Minato-ku Tokyo 108-0014 (JP)
(72) Inventor: KUMAGAI, Tomoki, Tokyo, 960-0719 (JP)
(74) Representative: Goddar, Heinz J.

(57) **Abstract**

A connector board configured to be electrically connected to a terminal of a communication cable including a differential pair wire composed of two signal wires, each signal wire having a conductor at a center and an insulation layer covering the conductor, wherein the signal wire or the differential pair wire is provided with a shield layer. The connector board includes a substrate; a pair of terminals formed on one surface of the substrate and configured to be connected to the conductors of the two signal wires; and a shield terminal formed on the one surface of the substrate and configured to be connected to the shield layer, and the shield terminal is arranged on a communication cable-side of the pair of terminals.

## Description

### CROSS-REFERENCE TO RELATED APPLICATIONS

The present patent application claims the priority of Japanese patent application No. 2023-142525 filed on September 1, 2023, and the entire contents thereof are hereby incorporated by reference.

### TECHNICAL FIELD

This disclosure relates to a connector board.

### BACKGROUND OF THE INVENTION

In recent years, transmission cables that can reduce costs and improve transmission characteristics have been proposed (see, for example, Patent Literature 1).

The USB (Universal Serial Bus) standard, one of the interface standards, has been developed in various ways, and the maximum transfer rate has been improved. For example, USB 1.0 and USB 1.1 have a maximum transfer rate of 12 Mbps. USB2.0 has a maximum transfer rate of 480 Mbps, USB3.0 has a maximum transfer rate of 5 Gbps, and USB3.1 has a maximum transfer rate of 10 Gbps, and USB3.2 has a maximum transfer rate of 20 Gbps. On the other hand, for connectors, Type-A and Type-B connectors have been specified, but Type-C, which has a reversible connector, is specified for USB 3.1 and later.

In addition, USB cables have become capable of various types of communication with a single cable. This has led to an increase in the complexity of the core wire configuration and the number of cores. For example, it is recommended that USB 2.0 has four cores, USB 3.0 has eight cores, and USB Type-C has fifteen cores.

The transmission cable described in Patent Literature 1 is a transmission cable compliant with the USB Type-C standard. This transmission cable is a 17-core cable that includes eight coaxial wires (for 10Gbps transmission), four signal wires (a first SBU wire, a second SBU wire, a configuration channel (CC) wire, and a Vconn wire), one power wire, two ground wires, and a pair of twisted pair wires.

### Citation List Patent Literature 1: JP2017-10747A

### SUMMARY OF THE INVENTION

Conventional transmission cables compliant with the USB Type-C standard are mainstream in many countries as charging cables for smartphones. In addition, there is a movement to adopt the USB Type-C standard as power cables and communication cables not only for smartphones but also for PCs, other communication devices, and imaging devices. This is thought not to standardize cable characteristics but to unify connector plugs (mating parts) and receptacles of devices to be connected to increase convenience. On the other hand, the USB Type-C standard defines specifications for both the cable and the connector. In such transmission cables compliant with the USB Type-C standard, the number of core wires is large so that the number of pads on the connector board is increased. This makes the area of each pad smaller due to the size limitation of the board, which makes it difficult to connect the cables.

Therefore, an object of the present invention is to provide a connector board with excellent workability in connecting a cable to the connector board.

For solving the above problem, the first aspect provides a connector board configured to be electrically connected to a terminal of a communication cable comprising a differential pair wire composed of two signal wires, each signal wire comprising a conductor at a center and an insulation layer covering the conductor, wherein the signal wire or the differential pair wire is provided with a shield layer, the connector board comprising: a substrate; a pair of terminals formed on one surface of the substrate and configured to be connected to the conductors of the two signal wires; and a shield terminal formed on the one surface of the substrate and configured to be connected to the shield layer, the shield terminal being arranged on a communication cable-side of the pair of terminals.

The second aspect provides the connector board, according to the first aspect, wherein the differential pair wire comprises two differential pair wires, wherein the pair of terminals comprise a pair of front surface terminals formed on a front surface of the substrate and configured to be connected to the conductors of one differential pair wire of the two differential pair wires, and a pair of back surface terminals formed on a back surface of the substrate and configured to be connected to the conductors of an other differential pair wire of the two differential pair wires, and wherein the shield terminal comprises a front surface shield terminal formed on the front surface of the substrate and arranged on a communication cable-side of the pair of front surface terminals, and a back surface shield terminal formed on the back surface of the substrate and arranged on a communication cable-side of the pair of back surface terminals.

The third aspect provides the connector board, according to the second aspect, wherein the communication cable further comprises a configuration channel wire for detecting front and back orientation of a plug, and wherein the connector board further comprises a configuration channel terminal formed on the front surface or the back surface of the substrate and configured to be connected to the configuration channel wire.

### Advantageous Effects of the Invention

The first aspect of the invention enhances the workability of cable connection.

The second aspect of the invention can make the connector board compact.

The third aspect of the invention allows the use of a reversible plug that can be plugged into a receptacle even when the front and back are reversed.

### BRIEF DESCRIPTION OF DRAWINGS

FIGS. 1A and 1B are plan views showing examples of a communication cable assembly according to the first embodiment.
FIG. 1C is a side view of a mating part and pins of a plug of the communication cable assembly according to the first embodiment.
FIG. 2 is a cross-sectional view of an example of the communication cable shown in FIG. 1.
FIGS. 3A and 3B show a connector board corresponding to cables compliant with the USB Type-C standard. FIG. 3A shows a plan view of the connector board viewed from the front side, and FIG. 3B shows a plan view of the connector board viewed from the back side.
FIGS. 4A and 4B show an example of a connector board in the first embodiment, wherein FIG. 4A is a plan view of the connector board viewed from the front side, and FIG. 4B is a plan view of the connector board viewed from the back side.
FIGS. 5A and 5B show the connection of the first differential pair wire to the connector board shown in FIGS. 4A and 4B, wherein FIG. 5A is a plan view of the connector board viewed from the front side and FIG. 5B is a plan view of the connector board viewed from the back side.
FIG. 6 is a cross-sectional view of an example of a communication cable in the second embodiment.
FIG. 7 is a cross-sectional view of an example of a communication cable in the third embodiment.
FIG. 8 is a cross-sectional view showing an example of a communication cable in the fourth embodiment.
FIGS. 9A and 9 B show the connection of the first differential pair wire to the connector board shown in FIGS. 4A and 4B, wherein FIG. 9A is a plan view of the connector board viewed from the front side and FIG. 9B is a plan view of the connector board viewed from the back side.
FIG. 10 is a cross-sectional view of a communication cable in the fifth embodiment.

### DETAILED DESCRIPTION OF THE INVENTION

### [Embodiments]

Next, the embodiments will be described with reference to the appended drawings. In each of the figures, the same symbols are used for components that have substantially the same functions in the figures, and redundant descriptions are omitted.

### [First embodiment]

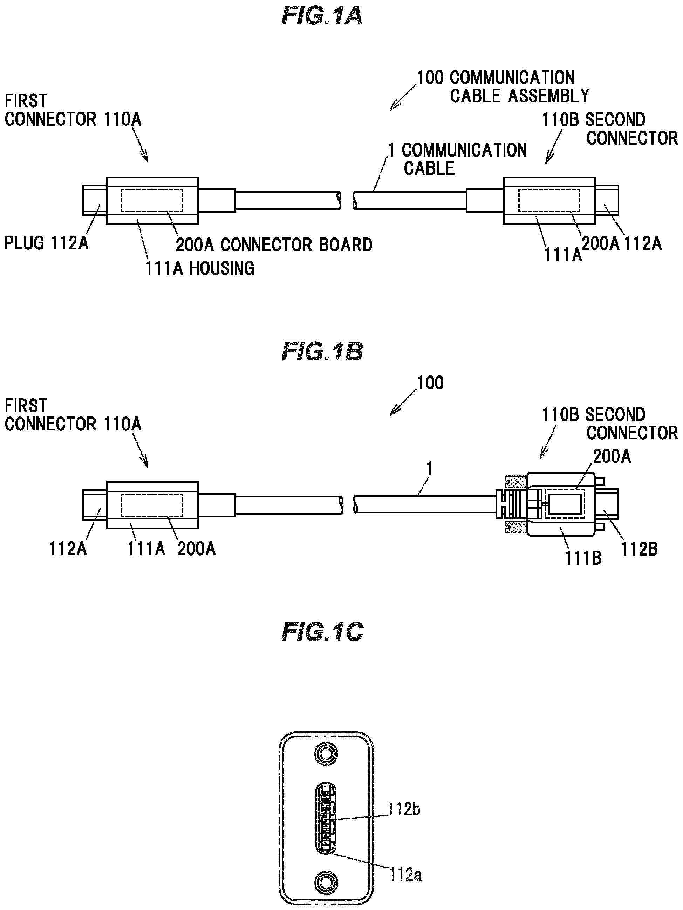

FIGS. 1A and 1B are plan views showing examples of a communication cable assembly according to the first embodiment. This communication cable assembly 100 comprises a communication cable 1 of a predetermined length within a communication distance, a first plug connector (hereinafter abbreviated as "first connector") 110A, which is connected to one end of the communication cable 1, and a second plug connector (hereinafter abbreviated as "second connector") 110B, which is connected to the other end of the communication cable 1. FIG. 1C is a side view of a mating part 112a and pins 112b of a plug 112A or 112B.

The communication cable 1 is a 9-core cable with a reduced number of cores compared to the core wire configuration of a cable compliant with the USB Type-C standard. In other words, a cable compliant with the USB Type-C standard has four pairs of high-frequency signal wires (SSTX1 wire, SSRX1 wire, SSTX2 wire, and SSRX2 wire), but this communication cable 1 has only two pairs of high-frequency signal wires (e.g., SSTX1 wire, SSRX1 wire).

In addition, a conventional cable compliant with the USB Type-C standard includes the signal wires (SBU1 wire, SBU2 wire) for the alternate mode (HDM (registered trademark) DisplayPort, etc.). However, this communication cable 1 has no alternate mode. In other words, this communication cable 1 does not include the signal wires (SBU1 and SBU2 wires), or it is specialized for USB signals. The signal wires (SBU1 and SBU2) may be added as necessary.

The above configuration reduces the number of core wires, and when the cable diameter is the same as the conventional cable compliant with the USB Type-C standard, the conductor diameters of the SSTX1 and SSRX1 wires can be increased, thereby extending the communication distance. In other words, the communication distance can be increased in relation to the cable diameter. In addition, the USB Type-C compliant CC wires can be left as they are, which allows the USB Type-C compliant CC wires to be connected to a USB Type-C compliant connector, i.e., a reversible plug that can be plugged into a receptacle even when the front and back (top and bottom) are reversed. In addition, the number of core wires can be reduced, which allows the core wires to be thicker, which has advantages in the selection of resin layer materials and manufacturing, as described below. In order to enjoy the convenience of the unification of connectors compliant with the USB Type-C standard, the shape and structure of the mating part of the connector should at least be consistent with the shape and structure of the mating part of the USB Type-C standard of the device to be connected. The shape and structure of the connector board and cable other than the mating part of the connector need not conform to the USB Type-C standard. In other words, the terminals of the communication cable 1 are electrically connected to the pins 112b in the plug 112A or the plug 112B. While the plug 112A, 112B includes a mating part 112a and pins 112b having a shape and configuration compliant with USB Type-C standard, the number of pins 112b in the plug 112A, 112B that are electrically connected to the communication cable 1 is less than the number of pins compliant with the USB type-C standard. Namely, the number of terminals of the communication cable 1 that are electrically connected to the pins 112b is less than the number of pins in the plug compliant with the USB type-C standard. In addition, since the cable length can be increased without degrading communication quality and the cable can be made lighter, it can be used for in-vehicle equipment, for example.

The first connector 110A is connected to, e.g., a receptacle in a computer and has a resin housing 111A, a plug 112A exposed from the housing 111A, and a connector board 200 located in the housing 111A. The connector board 200A of the first connector 110A electrically connects the plug 112A to one terminal of the communication cable 1.

The second connector 110B is connected to, e.g., a receptacle provided in a peripheral device and uses the same connector as the first connector 110A, as shown in FIG. 1A. In other words, the second connector 110B has a housing 111A made of resin, a plug 112A exposed from the housing 111A, and a connector board 200A located in the housing 111A. The connector board 200A of the second connector 110B electrically connects the plug 112A to the other end of the communication cable 1.

As shown in FIG. 1A, the first connector 110A and the second connector 110B use the same connector, but as shown in FIG. 1B, different connectors may be used. For example, the second connector 110B has a housing 111B made of resin and having a screw to prevent connector disconnection, a plug 112B exposed from the housing 111B, and a connector board 200A located in the housing 111B. In the present embodiment, the connector board 200A of the first connector 110A and the connector board 200A of the second connector 110B use the same board, but they may use different boards from each other.

### (Configuration of communication cable)

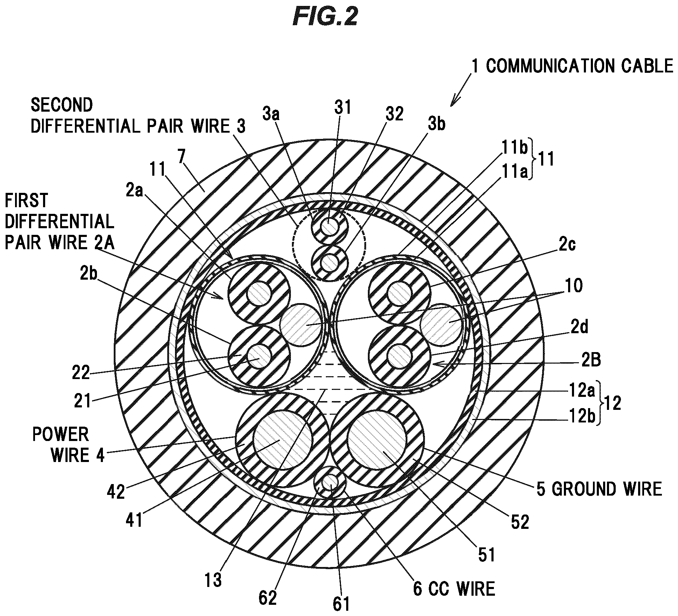

FIG. 2 is a cross-sectional view of the communication cable 1 shown in FIGS. 1A and 1B. This communication cable 1 includes two first differential pair wires 2A and 2B that transmit high-speed differential signals (e.g., 5 Gbps to 20 Gbps), a second differential pair wire 3 that transmits low-speed differential signals (e.g., 480 Mbps), a power wire 4 (Vbus wire), a ground wire 5, a configuration channel wire (hereinafter referred to as the "CC wire") 6 for detecting the front and back orientation of the plug according to the USB Type-C standard, and is a 9-core cable having no other differential pair wires than the two first differential pair wires 2A and 2B, as the first differential pair wire. In other words, the communication cable 1 is devoid of other first differential pair wires than the two first differential pair wires 2A and 2B. The communication cable 1 is not limited to a 9-core cable, but may be a cable with 10 or more cores or 14 or less cores. 14 or less cores can be used to differentiate it from the recommended number of cores in the USB Type-C standard (15-cores). In addition, the CC wire 6 may not conform to the USB Type-C standard.

Of the signal wires 2a to 2d that constitute the first differential pair wires 2A and 2B, the two adjacent signal wires 2a and 2b constitute a first differential pair, and the other two adjacent signal wires 2c and 2d constitute a second differential pair. The pair of signal wires 2a and 2b are twisted together with the drain wire 10 and covered collectively by the shield layer 11, thus constituting the first Twinax cable. The other pair of signal wires 2a and 2b are also twisted together with the drain wire 10 and covered collectively by the shield layer 11, thus constituting the second Twinax Cable. The communication cable 1 using a Twinax cable for the first differential pair wires 2A and 2B is hereinafter also referred to as a Twinax type communication cable. A non-twisted type of Twinax cable may also be used as a Twinax cable. The drain wire 10 is, for example, a stranded wire made by twisting together a plurality of metal strands. The signal wires 2a to 2d are examples of signal wires constituting the first differential pair wire.

Each of the signal wires 2a to 2d has a conductor 21 and an insulation layer 22 that covers the conductor 21. The conductor 21 is, for example, a stranded wire consisting of a plurality of metal strands twisted together. The insulation layer 22 is formed from a resin material (e.g., cross-linked polyethylene). The conductor 21 is an example of a center conductor.

The shield layer 11 is provided with an inner shield layer 11a, which is provided inside and formed by wrapping electrically conductive tape (e.g., tape laminated with aluminum and polyester), and an outer shield layer 11b, which is provided outside the inner shield layer 11a and formed by wrapping resin tape (e.g., polyester tape).

A second differential pair wire 3 consists of two signal wires 3a and 3b twisted together. Each of the signal wires 3a and 3b has a conductor 31 and an insulation layer 32 that covers the conductor 31. The conductor 31 is, for example, a stranded wire made by twisting together a plurality of metal strands. The insulation layer 32 is formed from a resin material (e.g., cross-linked polyethylene).

The power wire 4 has a conductor 41 and an insulation layer 42 that covers the conductor 41. The conductor 41 is, for example, a stranded wire consisting of a plurality of metal strands twisted together. The insulation layer 42 is formed from a resin material (e.g., cross-linked polyethylene).

The ground wire 5 has a conductor 51 and an insulation layer 52 that covers the conductor 51. The conductor 51 is, for example, a stranded wire consisting of a plurality of metal strands twisted together. The insulation layer 52 is formed from a resin material (e.g., cross-linked polyethylene). The ground wire 5 may be a bare wire without an insulation layer on its periphery.

The CC wire 6 has a conductor 61 and an insulation layer 52 that covers the conductor 61. The conductor 61 is, for example, a stranded wire consisting of a plurality of metal strands twisted together. The insulation layer 62 is formed from a resin material (e.g., polyvinyl chloride).

The first differential pair wires 2A, 2B, the second differential pair wire 3, the power wire 4, the ground wire 5, and the CC wire 6 are covered by the shield layer 12 together with the filler string 13, and the outside of the shield layer 12 is covered by a sheath 7. The sheath 7 is formed from a resin material (e.g., polyvinyl chloride) with a thickness of about 0.6 to 0.9 mm. The filler string 13 is formed from a fibrous material (e.g., cotton, silk, etc.). The filler string 13 is an example of a filler material.

The shield layer 12 is provided with an inner shield layer 12a, which is provided inside and formed by wrapping electrically conductive tape (e.g., tape laminated with aluminum and polyester), and an outer shield layer 12b, which is provided outside the inner shield layer 12a and formed from metal braid (e.g., tin-plated soft copper wire braid).

### (Connector board configuration)

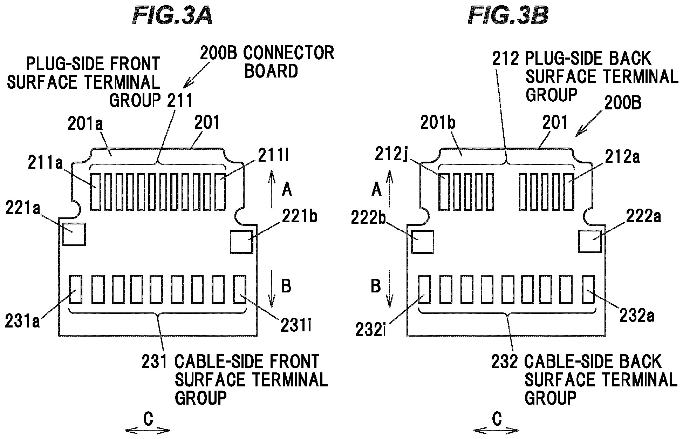

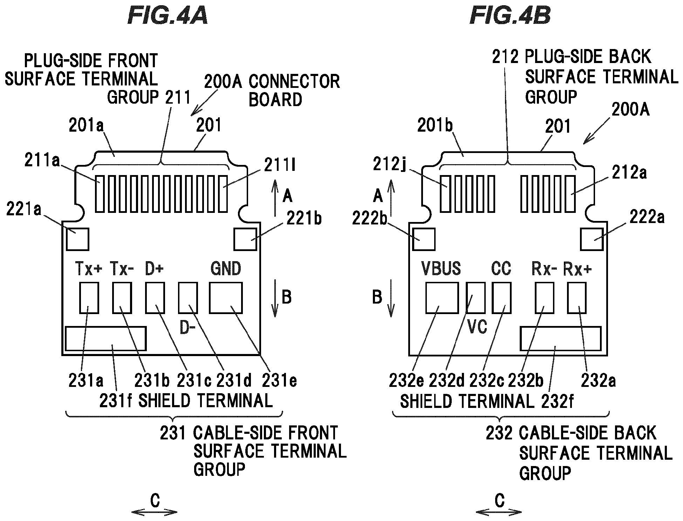

FIGS. 3A and 3B show a connector board 200B corresponding to cables compliant with the USB Type-C standard, FIG. 3A is a plan view of the connector board 200B viewed from the front side, and FIG. 3B is a plan view of the connector board 200B viewed from the back side. FIGS. 4A and 4B show an example of connector board 200A in the present embodiment. FIG. 4A is a plan view of the connector board 200A viewed from the front side, and FIG. 4B is a plan view of the connector board 200A viewed from the back side. In FIGS. 3A, 3B, 4A, and 4B, A indicates the plug-side, B indicates the cable-side, and C indicates the width direction of the connector board.

### (Connector board configuration corresponding to cables compliant with USB Type-C standard)

As shown in FIGS. 3A and 3B, the connector board 200B, which is compatible with cables conforming to the USB Type-C standard, has a configuration that can accommodate an 18-core cable, i.e., the number of terminals (also called "pads") is 18 and has a substrate 201 formed from electrically insulating material.

As shown in FIG. 3A, a front surface 201a of the substrate 201 is formed with a plug-side front surface terminal group 211 consisting of terminals 211a to 211l provided on the plug-side A, terminals 221a and 221b provided in the middle between the plug-side A and cable-side B, and a cable-side front surface terminal group 231 consisting of terminals 231a to 231i provided on the cable-side B.

As shown in FIG. 3B, a back surface 201b of the substrate 201 is formed with a plug-side back surface terminal group 212 consisting of terminals 212a to 212j provided on the plug-side A, terminals 222a and 222b provided in the middle between the plug-side A and cable-side B, and a cable-side back surface terminal group 232 consisting of terminals 232a to 232i provided on the cable-side B.

The terminals 231a to 231i of the cable-side front surface terminal group 231 are formed with a pitch of 0.9 to 1.0 mm, and the terminals 232a to 232i of the cable-side back surface terminal group 232 are formed with a pitch of 0.9 to 1.0 mm. In other words, the minimum pitch of the terminals in the width direction C of the connector board 200B is 0.9 mm.

### (Configuration of the connector board in the present embodiment)

A connector board 200A is compliant with the USB Type-C standard, but as shown in FIGS. 4A and 4B, it has a configuration that is compatible with 9-core and 10-core cables, i.e., the number of terminals (also called "pads") is 10, and has a substrate 201 formed from electrically insulating material.

As shown in FIG. 4A, a front surface 201a of the substrate 201 is formed with a plug-side front surface terminal group 211 consisting of terminals 211a to 211l provided on the plug-side A, terminals 221a and 221b provided in the middle between the plug-side A and the cable-side B for a metal cover (not shown) on a plug 112A, and a cable-side front surface terminal group 231 consisting of terminals 231a to 231f provided on the cable-side B. Among the cable-side front surface terminal group 231, the terminal 231f is a shield terminal and has a rectangular shape with a longitudinal direction being the width direction C of the connector board 200A. The terminals 231a and 231b of the cable-side front surface terminal group 231 are examples of a pair of front surface terminals. The shield terminal 231f is an example of a front surface shield terminal.

As shown in FIG. 4B, a back surface 201b of the substrate 201 is formed with a plug-side back surface terminal group 212 consisting of terminals 212a to 212j provided on the plug-side A, terminals 222a and 222b provided in the middle between the plug-side A and the cable-side B for a metal cover (not shown) on the plug 112A, and a cable-side back surface terminal group 232 consisting of terminals 232a to 232f provided on the cable-side B. Among the cable-side back surface terminal group 232, the terminal 232f is a shield terminal and has a rectangular shape with a longitudinal direction being the width direction C of the connector board 200A. The front surface 201a and the back surface 201b are examples of one surface. The terminals 232a and 232b of the cable-side back surface terminal group 232 are examples of a pair of back surface terminals. The shield terminal 232f is an example of a back surface shield terminal. The terminal 232c of the cable-side back surface terminal group 232 is an example of a configuration channel terminal, and may be included in the cable-side front surface terminal group 231. Preferably, the connector board 200A is devoid of other terminal pairs than the two terminal pairs, i.e. a pair of front surface terminals 231a, 231b and a pair of back surface terminals 232a, 232b.

The terminals 231a to 231e, excluding the shield terminal 231f, of the cable-side front surface terminal group 231 are formed with a pitch of 1.0 to 1.57 mm, and the terminals 232a to 232e, excluding the shield terminal 232f, of the cable-side back surface terminal group 232 are formed with a pitch of 1.2 to 2.0 mm. In other words, the minimum pitch of the terminals in the width direction C of the connector board 200A is 1.2 mm.

According to this connector board 200A, the minimum pitch of terminals in the width direction C can be increased to 1.3 times or more than the minimum pitch in the width direction C of the connector board 200B, compliant with the USB Type-C standard. In addition, since the number of cable cores has been reduced, the number of pads on the connector board 200A can also be reduced, and the pad width can be increased from 0.5 mm to 0.8 mm, for example, for the same dimensions and area as the connector board 200B compliant with the USB Type-C standard. The above configuration enables connection work to be performed with the naked eye. In addition, the work of connecting the communication cable 1 to the connector board 200A can be performed without using a jig (alignment component) that aligns and holds the terminals in the communication cable 1 to be connected.

### (Method of manufacturing a communication cable assembly)

Next, an example of the manufacturing method of a communication cable assembly 100 will be described.

First, two first differential pair wires 2A, 2B, a second differential pair wire 3, a power wire 4, a ground wire 5, a CC wire 6, and a filler 13 are prepared. For the first differential pair wires 2A and 2B, two signal wires 2a, 2b or signal wires 2c, 2d and a drain wire 10, respectively, are twisted together while conductive tape is wrapped around the outer circumference to form an inner shield layer 11a and resin tape is wrapped around the outer circumference of the inner shield layer 1 1a to form an outer shield layer 11b. The second differential pair wire 3 is formed by twisting two signal wires 3a and 3b together.

Next, the two prepared first differential pair wires 2A, 2B, the second differential pair wire 3, the power wire 4, the ground wire 5, the CC wire 6, and the filler 13 are twisted together and conductive tape is wrapped around the outer circumference of these wires to form the inner shield layer 12a, and metal braid is wrapped around the outer circumference of the inner shield layer 12a to form the outer shield layer 12b. Next, a sheath 7 is formed around the outer circumference of the shield layer 12 by extrusion using an extruder.

The communication cable 1 is manufactured in the manner described above. The communication cable 1 is then cut to the required length, and the terminals are connected to the connector board 100A of the first connector 110A and the connector board 100A of the second connector 110B, thereby producing a communication cable assembly 100 including the communication cable 1, and the first connector 110A and the second connector 110B at both ends of the communication cable 1. The work of connecting the first differential pair wires 2A and 2B to the connector board 100A is described below.

### (Connection work of the first differential pair wires)

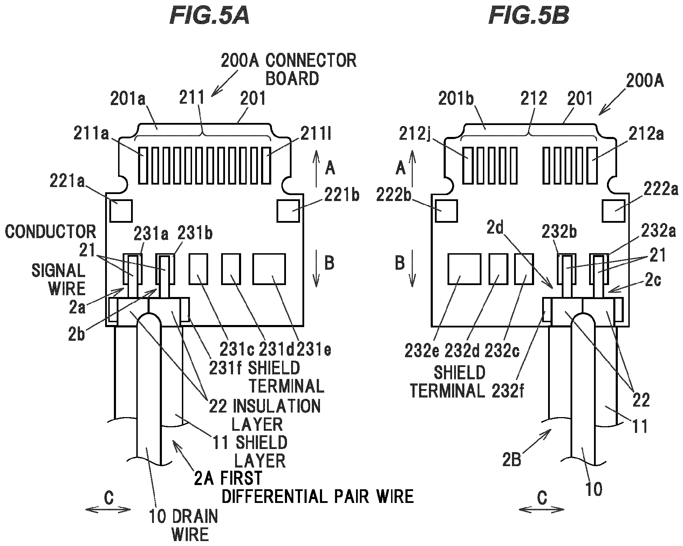

FIGS. 5A and 5B show the connection of the signal wires 2a to 2d of the first differential pair wires 2A and 2B to the connector board 100A shown in FIGS. 4A and 4B, in which FIG. 5A is a plan view of the connector board 100A viewed from the front side and FIG. 5B is a plan view of the connector board 100A viewed from the back side.

When connecting the conductors 21 of the signal wires 2a and 2b of the communication cable 1 of the first embodiment to the terminals 231a and 231b of the cable-side front surface terminal group 231 of the connector board 200B corresponding to the cable compliant with the USB Type-C standard shown in FIG. 3A, the shield layer 11 must be peeled off, and then the insulation layers 22 of the signal wires 2a and 2b must be peeled off, and the exposed conductors 21 must be connected to the terminals 231a and 231b with a narrow pitch. On the other hand, when connecting the conductors 21 of the signal wires 2a and 2b to the terminals 231a and 231b of the cable-side front surface terminal group 231 of the connector board 200A shown in FIG. 4A, the terminals 231a and 231b have a wide pitch, making the work of connecting the signal wires 2a and 2b easier. This is also applicable for the back surface 201b of the connector board 200a shown in FIG. 4B. The drain wire 10 is pulled out from the shield layer 11 and connected to the metal cover (not shown) of the plug 112A.

### (Effects of the first embodiment)

According to the first embodiment of the communication cable assembly 100, the following effects are achieved.
(a) The number of cores can be reduced compared to the core wire configuration of cables compliant with the USB Type-C standard, which reduces manufacturing costs and lightens the weight.
(b) When the cable outer diameters are the same, the outer diameter of the core wire can be increased, which enables various characteristics (communication performance, bending resistance (refers to the characteristics of resistance to wire breakage when the cable is repeatedly bent. The same applies hereafter), and mechanical strength). In addition, the thicker conductor reduces the risk of wire breakage due to injection pressure during molding, thereby expanding the options for molding methods. Further, when the cable outer diameters are the same, the core wires such as signal wires 2a and 2b can be made thicker, which expands the range of selection of materials for the insulation layer, for example, from expensive nylon resins such as polyamide to inexpensive polyolefin resins such as polyethylene. It is also possible to shorten the molding time by changing the molding machine from a dedicated low-pressure molding machine to a general-purpose molding machine that performs injection molding.
(c) Since the communication distance of high-speed differential signals relative to the cable diameter can be increased when the cable diameter is reduced (e.g., 3.7 mm), the communication cable can be made lighter without reducing the communication distance. When the cable diameter is the same as before (e.g., 6.8 mm), the communication distance can be increased because the conductors 21 of the first differential pair wires 2A and 2B can be made thicker.
(d) The CC wire 6 allows the use of a reversible plug that can be plugged in even when the front and back (top and bottom) are reversed with respect to the receptacle.
(e) The pitch of terminals 231a and 231b and the pitch of terminals 232a and 232b of connector board 200A are wide, which makes it easy to connect the signal wires 2a to 2d, which constitute the first differential pair wires 2A and 2B, to the connector board 200A.

### [The second embodiment]

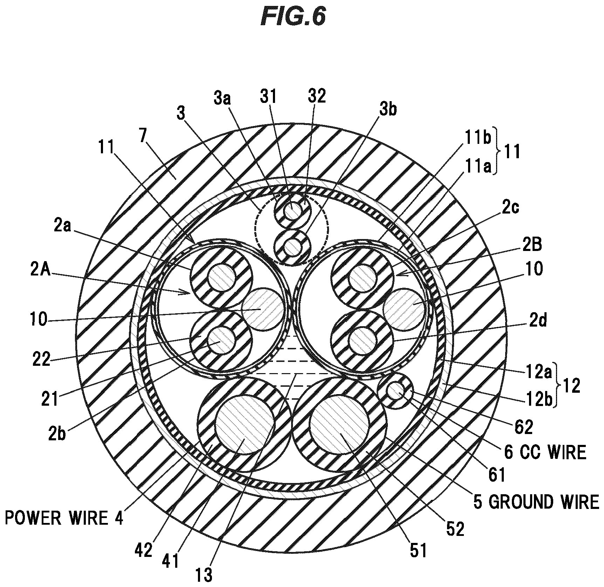

FIG. 6 is a cross-sectional view of a communication cable of the second embodiment. In the communication cable 1 of the first embodiment, the CC wire 6 was placed between the power wire 4 and the ground wire 5. In the communication cable 1 of the present embodiment, the CC wire 6 is placed at the position where it contacts the shield layer 11 covering the first differential pair wire 2B and the ground wire 5, thereby reducing the conductor diameter of the conductors 21 of the signal wires 2a to 2d to reduce the cable diameter. Since the communication cable assembly 100 of the second embodiment is manufactured in the same way as the first embodiment, its description is omitted.

According to the second embodiment, by selecting the outer diameters of the power wire 4, ground wire 5, and CC wire 6 as appropriate, the cable outer diameter can be made smaller than in the first embodiment without shortening the communication distance for high-speed differential signals.

### [The third embodiment]

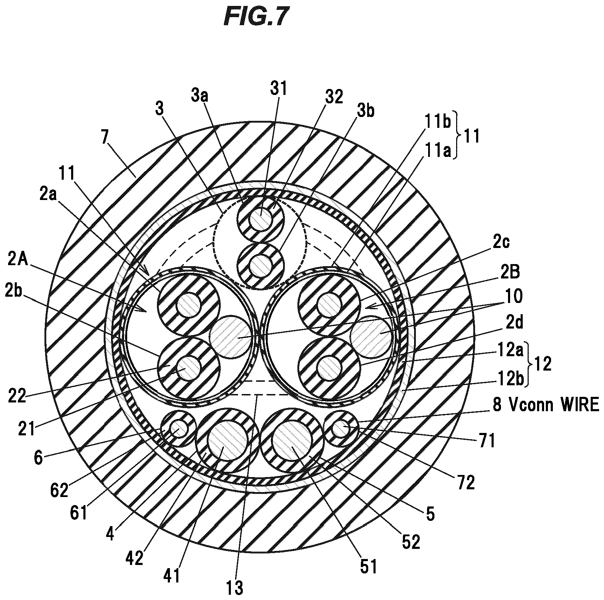

FIG. 7 is a cross-sectional view of a communication cable of the third embodiment. The communication cable 1 of the first embodiment is a 9-core cable, but the communication cable 1 of the present embodiment is a 10-core cable by adding a power wire for circuits in the plug (hereinafter referred to as "Vconn wire") conforming to the USB Type-C standard to the communication cable 1 of the first embodiment. The following explanation focuses on the points that differ from the first embodiment.

Similarly to the first embodiment, the communication cable 1 of the third embodiment is a 10-core cable including two first differential pair wires 2A and 2B, a second differential pair wire 3, a power wire 4, a ground wire 5, and a CC wire 6 compliant with the USB Type-C standard, as well as a Vconn wire 8. The communication cable 1 is not limited to a 10-core cable but may have 11 or more cores. The Vconn wire 8 may not conform to the USB Type-C standard.

The Vconn wire 8 has a conductor 81 and an insulation layer 82 that covers the conductor 81. The conductor 81 is, for example, a stranded wire consisting of a plurality of metal strands twisted together. The insulation layer 82 is formed from a resin material (e.g., polyvinyl chloride).

In the first embodiment, the CC wire 6 is placed between the power wire 4 and the ground wire 5, but in the present embodiment, the CC wire 6 is placed alongside the power wire 4 and the ground wire 5, with the CC wire 6 on one side of them and the Vconn wire 8 on the other side. The CC wire 6 and the Vconn wire 8 are connected to the plug's built-in IC chip (eMarker). The communication cable assembly 100 of the third embodiment is manufactured in the same way as the first embodiment, so its description is omitted.

According to the third embodiment, the same effect as the first embodiment is achieved, and since the CC wire 6 and the Vconn wire 8 are provided, the charger and the device can be connected with the communication cable 1 to enable high-speed charging of the device with a power corresponding to the USB PD (Power Delivery) standard.

### [The fourth embodiment]

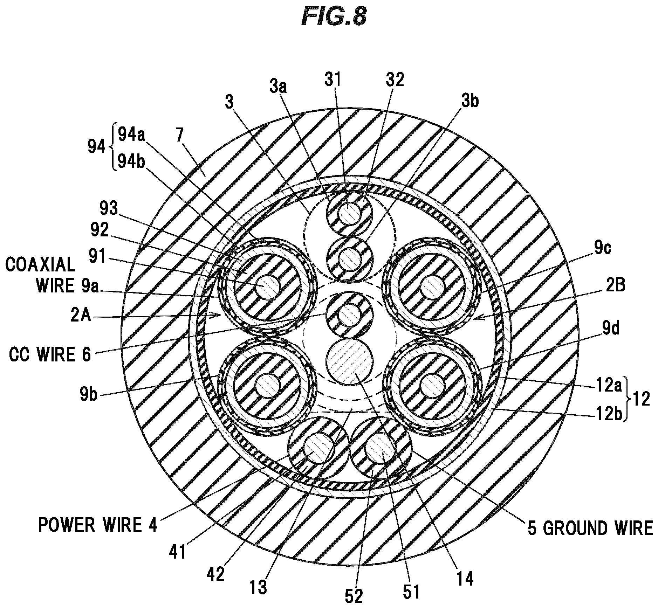

FIG. 8 is a cross-sectional view of an example of a communication cable of the fourth embodiment of the invention. In the communication cable 1 of the first embodiment, the first differential pair wire of signal wires 2a and 2b and the second differential pair wire of signal wires 2c and 2d, which constitute the two first differential pair wires 2A and 2B, respectively, are collectively shielded by the shield layer 11. The communication cable 1 of the present embodiment is a cable using coaxial wires (coaxial cables) 9a to 9d as the signal wires that constitute the two first differential pair wires 2A and 2B (also called "Coaxial type communication cable"). The following explanation focuses on the points that differ from the first embodiment.

In the communication cable 1 of the fourth embodiment, a first differential pair wire 2A is composed of a first differential pair wire of coaxial wires 9a and 9b, a first differential pair wire 2B is composed of a second differential pair wire of coaxial wires 9c and 9d, these coaxial wires 9a to 9d are arranged on the outer circumference, and a CC wire 6 and a filler string 14 are arranged in the center, the first differential pair wires 2A, 2B, a second differential pair wire 3, a power wire 4 and a ground wire 5 are covered by a shield layer 12 together with a filler string 13, and the outside of the shield layer 12 is covered by a sheath 7. The filler string 14 is formed from a resin material (e.g., polyethylene). The coaxial wires 9a to 9d are examples of signal wires constituting the first differential pair wire. The filler string 14 is an example of a filler.

Each of the coaxial wires 9a to 9d has a center conductor 91, an inner insulation layer 92 covering the center conductor 91, an outer conductor 93 formed outside the inner insulation layer 92, and an outer insulation layer 94 covering the outer conductor 93. The center conductor 91 is, for example, a stranded wire formed by twisting together a plurality of metal strands. The inner insulation layer 92 is formed from a resin material (e.g., cross-linked polyethylene). The outer conductor 93 is formed from, for example, a metal braid. The outer insulation layer 94 is formed from a resin material (e.g., polyvinyl chloride). The center conductor 91 is an example of a center conductor.

### (Method of manufacturing a communication cable assembly)

Next, an example of a manufacturing method for the communication cable assembly 100 of the fourth embodiment will be described.

First, two first differential pair wires 2A, 2B, a second differential pair wire 3, a power wire 4, a ground wire 5, a CC wire 6, and fillers 13 and 14 are prepared. For the first differential pair wires 2A and 2B, four coaxial wires 9a to 9d constituting them are prepared. The second differential pair wire 3 is formed by twisting two signal wires 3a and 3b together.

Next, the two prepared first differential pair wires 2A, 2B, the second differential pair wire 3, the power wire 4, the ground wire 5, the CC wire 6, and the fillers 13, 14 are twisted together, and conductive tape is wrapped around the outer circumference of these wires to form an inner shield layer 12a, and metal braid is wrapped around the outer circumference of the inner shield layer 12a to form an outer shield layer 12b. Next, a sheath 7 is formed around the outer circumference of the shield layer 12 by extrusion molding using an extruder.

The communication cable 1 is manufactured in the manner described above. The communication cable 1 is then cut to the required length and the terminals are connected to the connector board 100A of the first connector 110A and the connector board 100A of the second connector 110B, so that a communication cable assembly 100 is produced. The work of connecting the coaxial wires 9a to 9d, which constitute the first differential pair wires 2A and 2B, to the connector board 100A is described below.

### (Connection work of the first differential pair wire)

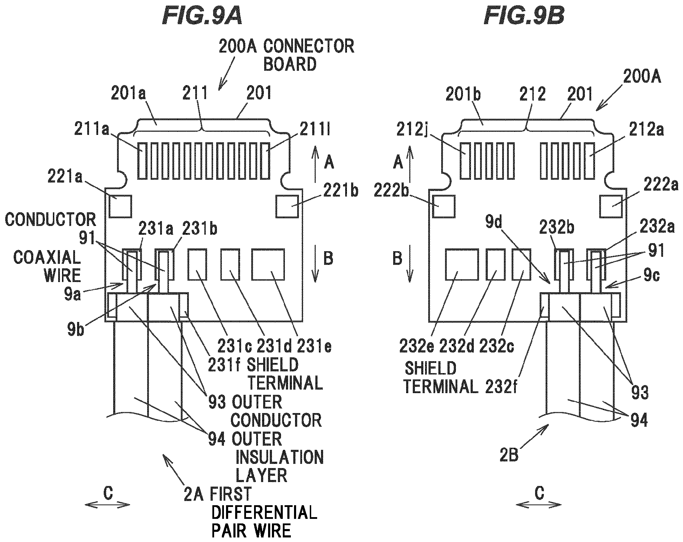

FIGS. 9A and 9B show the connection of the first differential pair wire to the connector board shown in FIGS. 4A and 4B, in which FIG. 9A is a plan view of the connector board viewed from the front side and FIG. 9B is a plan view of the connector board viewed from the back side.

When connecting the center conductors 91 of the coaxial wires 9a and 9b of the communication cable 1 of the fourth embodiment to the terminals 231a and 231b of the cable-side front surface terminal group 231 of the connector board 200B corresponding to the cable compliant with the USB Type-C standard shown in FIG. 3A, the outer insulation layer 94 must be peeled off, and then the inner insulation layer 92 of the coaxial wires 9a and 9b must be peeled off, and the exposed center conductors 91 must be connected to the terminals 231a and 231b with a narrow pitch. The outer conductor 93 must be pulled out like a single conductor and connected to the shield terminal (the metal cover (not shown) of the plug 112A. On the other hand, when connecting the center conductors 91 of the coaxial wires 9a and 9b to the terminals 231a and 231b of the cable-side front surface terminal group 231 of the connector board 200A shown in FIG. 4A, the terminals 231a and 231b have a wide pitch, making it easy to connect the coaxial wires 9a and 9b. Also, an outer circumference surface can be connected to the shield terminal 231f without having to pull out the exposed outer conductor 93 like a single conductor. This is also applicable for the back surface 201b of the connector board 200A shown in FIG. 4B.

### (Effects of the fourth embodiment)

According to the communication cable 1 of the fourth embodiment, the same effects as the first embodiment are achieved, and since the coaxial wires 9a to 9d are used as signal wires constituting the first differential pair wires 2A and 2B, the outer conductors 93 exposed by peeling off the outer insulation layer 94 of the coaxial wires 9a to 9d can be connected to the shield terminals 231f and 232f, making it easy to connect the coaxial wires 9a to 9d to the connector board 200A.

In addition, since the coaxial wires (coaxial cables) 9a to 9d are used as the first differential pair wire 2A, 2B, the coaxial wires 9a to 9d are independent from each other, so that the characteristic change in differential is very small, compared to the Twinax type communication cable, bending resistance can be improved. This is evident from the results of the following durability tests. Namely, an 8-core Coaxial type communication cable without the CC wire 6 was attached to a cable bear (registered trademark), and a durability test was conducted to perform moving bending of the cable under specified conditions repeatedly (moving distance: 1 m, bending speed: 30 times/minute, bending radius (inside): 75 mm). The results of the durability test showed that the required characteristics were maintained even after 30,000,000 cycles of bending by movement, although there was some damage to the sheath and some effects on transmission characteristics. On the other hand, in the Twinax-type communication cable with the same 8-core core wire configuration, when the moving bending exceeds 100,000 times, mechanical damage causes changes in transmission characteristics in the first differential pair wires 2A and 2B, resulting in communication degradation.

### [The fifth embodiment]

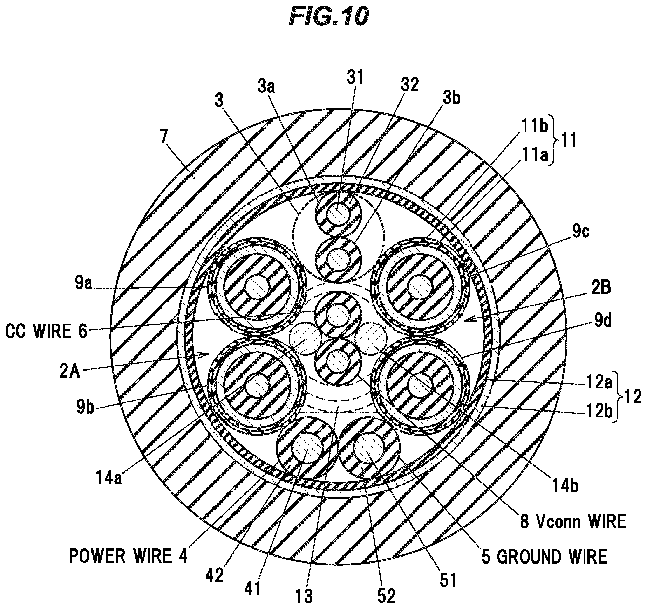

FIG. 10 is a cross-sectional view of a communication cable of the fifth embodiment. The communication cable 1 of the present embodiment is made by adding a Vconn wire 8 in the center to the communication cable 1 of the fourth embodiment and using two filler strings 14a and 14b formed from a resin material (e.g., polyethylene). The filler strings 14a and 14b are examples of filler. Since the communication cable assembly 100 of the fifth embodiment is manufactured similarly to the fourth embodiment, the description is omitted.

According to the communication cable 1 of the fifth embodiment, the same effects as the fourth embodiment are achieved, and since it is equipped with the CC wire 6 and the Vconn wire 8, it is possible to connect a charger and a device with the communication cable 1 and charge the device at high speed with a power corresponding to the USB PD (Power Delivery) standard. In addition, since the coaxial wires 9a to 9d are employed as the first differential pair wires 2A and 2B, bending resistance can be improved.

The above description is not limited to the above embodiments, but can be varied and implemented in various ways.

### (Summary of embodiments)

According to the first feature, a connector board 200A, 200B configured to be electrically connected to a terminal of a communication cable 1 includes a differential pair wire 2A, 2B composed of two signal wires 2a to 2d, each signal wire 2a to 2d comprising a conductor 21 at a center and an insulation layer 22 covering the conductor 21, wherein the signal wire 2a to 2d or the differential pair wire 2A, 2B is provided with a shield layer 11. The connector board 200A, 200B is provided with a substrate 201; a pair of terminals formed on one surface 201a, 201b of the substrate 201 and configured to be connected to the conductors 21 of the two signal wires 2a to 2d; and a shield terminal 231f, 232f formed on the one surface 201a, 201b of the substrate 201 and configured to be connected to the shield layer 11, the shield terminal 231f, 232f being arranged on a communication cable-side of the pair of terminals.

According to the second feature, in the connector board 200A, 200B, as described by the first feature, the differential pair wire 2A, 2B comprises two differential pair wires 2A, 2B, wherein the pair of terminals comprise a pair of front surface terminals 231a, 231b formed on a front surface 201a of the substrate 201 and configured to be connected to the conductors 21 of one differential pair wire 2A of the two differential pair wires 2A, 2B, and a pair of back surface terminals 232a, 232b formed on a back surface 201b of the substrate 201 and configured to be connected to the conductors 21 of the other differential pair wire 2B of the two differential pair wires 2A, 2B, and wherein the shield terminal 231f, 232f comprises a front surface shield terminal 231f formed on the front surface 201b of the substrate 201 and arranged on a communication cable-side of the pair of front surface terminals 231a, 231b, and a back surface shield terminal 232f, formed on the back surface 201b of the substrate 201 and arranged on a communication cable-side of the pair of back surface terminals 232a, 232b.

According to the third feature, in the connector board, as described by the second feature, the communication cable 1 further includes a configuration channel wire 6 for detecting front and back orientation of a plug 112A, 112B, and wherein the connector board 200A, 200B further comprises a configuration channel terminal 232c formed on the front surface 201a or the back surface 201b of the substrate 201 and configured to be connected to the configuration channel wire 6.

According to the sixth feature, a connector board 200A, 200B configured to electrically connect each of a pair of plugs 112A, 112B to each of both terminals of a communication cable 1 comprising two differential pair wires 2A, 2B each of which is composed of two signal wires 2a to 2d for transmitting high-speed differential signals, each signal wire 2a to 2d comprising a conductor 21 at a center and an insulation layer 22 covering the conductor 21, a configuration channel wire 6 for detecting front and back orientation of the pair of plugs 112A, 112B, wherein the communication cable 1 is devoid of other differential pair wires than the two differential pair wires 2A, 2B, wherein the signal wire 2a to 2d or the differential pair wire 2A, 2B is provided with a shield layer 11, wherein each of the pair of plugs 112A, 112B includes a mating part with a shape and configuration compliant with USB Type-C standard. The connector board 200A, 200B includes a substrate 201; a terminal group 211, 212 including a plurality of terminals formed on the substrate 201 and arranged in a direction perpendicular to a longitudinal direction of the communication cable 1, the plurality of terminals including two terminal pairs 231a, 231b, 232a, 232b configured to be connected to the conductors 21 of the two differential pair wires 2A, 2B, and a configuration channel terminal 232c configured to be connected to the configuration channel wire 6; and a shield terminal 231f, 232f formed on the substrate 201 and configured to be connected to the shield layer 11, the shield terminal 231f, 232f being arranged on a communication cable-side of the terminal group 211, 212, wherein the connector board 200A, 200b is devoid of other terminal pairs than the two terminal pairs 231a, 231b, 232a, 232b.

According to the fifth feature, the connector board 200A, 200B, as described by the fourth feature, wherein the two terminal pairs 231a, 231b, 232a, 232b comprise a pair of front surface terminals 231a, 231b formed on a front surface 201a of the substrate 201 and configured to be connected to the conductors 21 of one differential pair wire 2A of the two differential pair wires 2A, 2B, and a pair of back surface terminals 232a, 232b formed on a back surface 201b of the substrate 201 and configured to be connected to the conductors 21 of the other differential pair wire 2B of the two differential pair wires 2A, 2B, wherein the shield terminal 231f, 232f comprises a front surface shield terminal 231f formed on the front surface 201a of the substrate 201 and arranged on a communication cable-side of the pair of front surface terminals 231a, 231b, and a back surface shield terminal 232f formed on the back surface 201b of the substrate 201 and arranged on a communication cable-side of the pair of back surface terminals 232a, 232b, wherein, of the terminal group 211, 212, plural terminals including the pair of front surface terminals 231a, 231b are arranged in the direction perpendicular to the longitudinal direction on the front surface 201a of the substrate 201 and plural terminals including the pair of back surface terminals 232a, 232b are arranged in the direction perpendicular to the longitudinal direction on the back surface 201b of the substrate 201, and wherein the configuration channel terminal 232c is included in the plural terminals on the front surface 201a of the substrate 201 or the plural terminals on the back surface 201b of the substrate 201.

## Claims

1. A connector board configured to electrically connect each of a pair of plugs to each of both terminals of a communication cable comprising two differential pair wires each of which is composed of two signal wires for transmitting high-speed differential signals, each signal wire comprising a conductor at a center and an insulation layer covering the conductor, a configuration channel wire for detecting front and back orientation of the pair of plugs, wherein the communication cable is devoid of other differential pair wires than the two differential pair wires, wherein the signal wire or the differential pair wire is provided with a shield layer, wherein each of the pair of plugs comprises a mating part with a shape and configuration compliant with USB Type-C standard,
the connector board comprising:
a substrate;
a terminal group comprising a plurality of terminals formed on the substrate and
arranged in a direction perpendicular to a longitudinal direction of the communication cable, the plurality of terminals including two terminal pairs configured to be connected to the conductors of the two differential pair wires, and a configuration channel terminal configured to be connected to the configuration channel wire; and
a shield terminal formed on the substrate and configured to be connected to the shield layer, the shield terminal being arranged on a communication cable-side of the terminal group,
wherein the connector board is devoid of other terminal pairs than the two terminal pairs.

2. The connector board, according to claim 1, wherein the two terminal pairs comprise a pair of front surface terminals formed on a front surface of the substrate and configured to be connected to the conductors of one differential pair wire of the two differential pair wires, and a pair of back surface terminals formed on a back surface of the substrate and configured to be connected to the conductors of an other differential pair wire of the two differential pair wires,
wherein the shield terminal comprises a front surface shield terminal formed on the front surface of the substrate and arranged on a communication cable-side of the pair of front surface terminals, and a back surface shield terminal formed on the back surface of the substrate and arranged on a communication cable-side of the pair of back surface terminals,
wherein, of the terminal group, plural terminals including the pair of front surface terminals are arranged in the direction perpendicular to the longitudinal direction on the front surface of the substrate and plural terminals including the pair of back surface terminals are arranged in the direction perpendicular to the longitudinal direction on the back surface of the substrate, and
wherein the configuration channel terminal is included in the plural terminals on the front surface of the substrate or the plural terminals on the back surface of the substrate.

3. The connector board, according to claim 2, wherein a pitch of the pair of front surface terminals is 1.2 mm or more and a pitch of the pair of back surface terminals is 1.2 mm or more.
